(19) Europäisches Patentamt
European Patent Office
Office européen des brevets

(11) Veröffentlichungsnummer: **0 067 380**
**B1**

(12) **EUROPÄISCHE PATENTSCHRIFT**

(45) Veröffentlichungstag der Patentschrift: **27.05.87**

(21) Anmeldenummer: **82104906.1**

(22) Anmeldetag: **04.06.82**

(51) Int. Cl.⁴: **C 08 F 8/06,** H 01 B 1/12, H 01 L 31/02, H 01 L 29/28

(54) **Oxidiertes Polyacetylen und Verfahren zu seiner Herstellung.**

(30) Priorität: **16.06.81 DE 3123802**

(43) Veröffentlichungstag der Anmeldung: **22.12.82 Patentblatt 82/51**

(45) Bekanntmachung des Hinweises auf die Patenterteilung: **27.05.87 Patentblatt 87/22**

(84) Benannte Vertragsstaaten: **DE FR GB IT**

(56) Entgegenhaltungen:
**EP-A-0 044 935**
**EP-A-0 045 852**
**US-A-4 204 216**
**US-A-4 230 604**

**MATERIALS RESEARCH BULLETIN, Band 16, Nr. 10, Oktober 1981, Seiten 1229-1235, Pergamon Press, New York, USA A. PRON et al.: "Synthesis and characterization of new organic metals formed by interaction of FeC13 with polyacetylene (CH)x and poly(para)phenylene (C6H4)x"**

(73) Patentinhaber: **BAYER AG**
**Konzernverwaltung RP Patentabteilung**
**D-5090 Leverkusen 1 Bayerwerk (DE)**

(72) Erfinder: **Hocker, Jürgen, Dr.**
**Eichenweg 6**
**D-5060 Bergisch Gladbach 2 (DE)**
Erfinder: **Dhein, Rolf, Dr.**
**Deswatinesstrasse 30**
**D-4150 Krefeld (DE)**
Erfinder: **Merten, Rudolf, Dr.**
**Berta-von-Suttner-Strasse 55**
**D-5090 Leverkusen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**EP 0 067 380 B1**

**Beschreibung**

Die Erfindung betrifft ein neuartig oxidiertes Polyacetylen, ein Verfahren zu seiner Herstellung, sowie seine Verwendung als elektrischer Leiter, Halbleiter oder Photoleiter.

Polyacetylen zeigt spezifische elektrische Leitfähigkeiten zwischen $10^{-9}$ und $10^{-5}\Omega^{-1}cm^{-1}$ und ist somit ein Halbleiter [Makromol. Chem., Vol. *175*, 1565 (1978)].

Diese Leitfähigkeit läßt sich jedoch durch partielle Oxidation beträchtlich erhöhen. Läßt man gasförmiges $Cl_2$, $Br_2$, $J_2$, JCl, JBr, $AsF_5$, $SbF_5$ auf eine Polyacetylenfolie einwirken, so steigt die Leitfähigkeit auf bis zu $\sim 10^3\Omega^{-1}cm^{-1}$ and [J. Amer. Chem. Soc., Vol. *100*, 1013 (1978)].

Auch die Oxidation mit $AgBF_4$ bzw. $AgClO_4$ wurde vorgeschlagen (J. Chem. Soc., Chem. Comm. 1978, 489). Das Europäische Patent Nr. 0 022 271 beschreibt die Verwendung von Metall-Komplexen der Platin-Gruppe, Carbonium- bzw. Oxonium-Salzen, sowie Parabenzochinon-Derivaten zur Erhöhung der elektrischen Leitfähigkeit.

Die besten Leitfähigkeiten werden mit $J_2$ oder $AsF_5$ erhalten.

Die Leitfähigkeit organischer Polymere und Harze läßt sich nach US-Patent 4 230 604 durch mechanische Einarbeitung von stark ionischen Salzen erhöhen, die dort elektrolytische Leitfähigkeit entwickeln.

Europäisches Patent 44 935 lehrt, daß die mechanische Einarbeitung von schwarzem Phosphor und einer starken Lewis-Säure die elektrische Leitfähigkeit von Polyacetylen steigert.

Weiterhin kann, wie im Europäischen Patent 45 852 beschrieben, durch Einarbeitung von Phosphankomplexsalzen des einwertigen Kobalts die Leitfähigkeit von Polyacetylen erhöht werden.

Die meisten der bisher bekannten Reagenzien zur Erhöhung der elektrischen Leitfähigkeit durch partielle Oxidation sind entweder schwer zugänglich, toxisch, korrosiv, schwer zu handhaben, hydrolyseempfindliche oder leicht flüchtig.

Ziel der Erfindung war es, leicht zugängliche, wenig toxische, und schwerflüchtige Substanzen zu finden, die die elektrische Leitfähigkeit des Polyacetylens erhöhen.

Es wurde nun überraschenderweise gefunden, daß sich die elektrische Leitfähigkeit des Polyacetylens beträchtlich erhöhen läßt, wenn man es mit Salzen des dreiwertigen Eisens oder Kobalts partiell oxidiert.

Gegenstand der Erfindung ist somit Polyacetylen, dessen Leitfähigkeit durch Oxidation ("Dotierung") mit den leicht zugänglichen, wenig toxischen und schwerflüchtigen Salzen des dreiwertigen Eisens oder Kobalts erhöht wurde, das Verfahren zur Herstellung des partiell oxidierten Polyacetylens, sowie seine Verwendung als elektrische Leiter, Halbleiter oder Photoleiter.

Geeignete Salze sind $FeF_3$, $FeCl_3$, $FeBr_3$, $FeJ_3$, $Fe(ClO_4)_3$, $NH_4Fe(SO_4)_2$, $Fe(NO_3)_3$, Fe $PO_4$, $Fe_2$(oxalat)$_3$, $Fe_2(SO_4)_3$, Fe(acetat)$_3$, Fe[(acetat)$_2$OH], $K_3[Fe(CN)_6]$, $Na_3[Fe(CN)_6]$, Fe-citrat, Fe[2,4-pentandionat]$_3$, $Na_3$ $FeF_6$, $Fe_2C_{12}H_{48}N_{12}O_{12}S_3$=Tris(ethylendiamin)eisen-(III)-sulfat, Co $C_6H_{24}Cl_3N_6$=Tris(ethylendiamin)cobalt-(III)-chlorid, $K_3[Co(CN)_6]$, Co[2,4-pentandionat]$_3$, $Co[(NH_3)_5Cl]Cl_2$, $CoF_3$.

Besonders bevorzugt sind die Halogenide des dreiwertigen Eisens, $Fe(NO_3)_3$, Fe[(acetat)$_2$OH], insbesondere $FeCl_3$.

Die Salze können gegebenenfalls Kristallwasser enthalten.

Besonders geeignet sind weiterhin solche Salze des dreiwertigen Eisens oder Kobalts, die in einem organischen Lösungsmittel löslich oder leicht sublimierbar sind.

Die erfindungsgemäß eingesetzten Salze erhöhen die Leitfähigkeit der nach allen üblichen Verfahren hergestellten Polyacetylene. Geeignete Katalysatorsysteme zur Polymerisation von Acetylen sind insbesondere Ziegler-Natta-Katalysatoren [Polymer Journal, *2*, 231 (1971)] und Luttinger-Katalysatoren [J. Org. Chem. *27*, 1591 (1962)]. Besonders bevorzugt ist ein Katalysatorsystem, das aus 0,05—0,2 Mol einer Vanadiumverbindung I

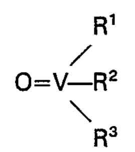 (I)

worin

$R^1$ für Halogen (Chlor),

$R^2$ und $R^3$ für Halogen (Chlor), $OR^5$ ($R^5=C_1—C_{20}$-Alkyl) steht, wobei $R^2$ und $R^3$ gleich oder verschieden sein können, und 0,1—4,0 Mol eines Trialkylaluminiums besteht.

Die Oxidation des Polyacetylens wird vorzugsweise in einem organischen oder anorganischen Lösungsmittel durchgeführt. Geeignete organische Lösungsmittel sind polare Lösungsmittel wie z.B. Methanol, Ethanol, Propanol, i-Propanol, Acetonitril, Aceton, Dimethylformamid, N-Methylpyrrolidon, Sulfolan, Nitromethan, Hexamethylphosphorsäuretrisamid, Propylencarbonat.

Auch Wasser bzw. ein Gemisch von Wasser mit einem Wassermischbaren organischen Lösungsmittel ist geeignet. Da Polyacetylen in allen üblichen Lösungsmitteln unlöslich ist, wird die Oxidation in einer Polyacetylensuspension durchgeführt.

In Ausnahmefällen kann auch—falls das Oxidationsmittel sublimierbar ist—in der Gasphase oxidiert werden.

Die Oxidation kann zwischen −80 und +200°C, vorzugsweise zwischen −40 und +80°C durchgeführt werden. Besonders zweckmäßig ist die Umsetzung bei Raumtemperatur.

Das zur Oxidation eingesetzte Polyacetylen kann als feines Pulver, in Form einer Folie oder als Gel vorliegen.

Besonders bevorzugt ist die Oxidation von Polyacetylenteilchen in Form von Partikeln eines Durchmessers von 0,01 bis 1 mm mit einer Vielzahl faserförmiger Fortsätze ("Kletten"), die man erhält, wenn man Acetylen in ein organisches Suspendiermittel unter ständigem Durchmischen in Gegenwart eines metallorganischen Mischkatalysators in einer Menge entsprechend 10—100 mmol Aluminium und 5—50 mmol Titantetrabutylat bzw. 1—10 mmol Bis - (2,2 - dimethylpropoxy) - vanadiumoxychlorid pro 1 Suspendiermittel bei −80°C einleitet, bis sich pro 1 Suspendiermittel ca. 3 g Polyacetylen gebildet hat.

Das Ausmaß der Oxidation ("Dotierung") läßt sich durch die eingesetzte Menge an Oxidationsmittel, durch die Einwirkungszeit, und durch die Temperatur steuern. Es ist somit möglich, die Leitfähigkeit des partiell oxidierten Polyacetylens zwischen $10^{-8}$ und $10^{+2}\Omega^{-1}cm^{-1}$ zu steuern.

Die Oxidation ("Dotierung") wird vorzugsweise in einer Inertgasatmosphäre durchgeführt, um die Oxidation des Polyacetylens durch Luftsauerstoff zu verhindern.

Die erfindungsgemäßen Produkte können als elektrische Leiter, Halbleiter oder Photoleiter sowie zur Dämpfung elektromagnetischer Strahlung Verwendung finden.

Dabei können die erfindungsgemäßen oxidierten Polyacetylene sowohl in Substanz eingesetzt, als auch einem anderen Polymeren als "Füllstoff" zugestezt und somit dessen elektrische Eigenschaften verbessert werden.

So können beispielsweise Kunststoffe, Lacke, Folien oder Fasern durch Zusatz der erfindungsgemäßen Produkte permanent antistatisch ausgerüstet werden.

In Substanz können die erfindungsgemäßen Produkte z.B. als Elektrodenmaterial in Batterien oder als Bestandteil photovoltaischer Wandler dienen.

Ausführungsbeispiele

Beispiel 1

Ein Streifen einer Polyacetylenfolie nach Shirakawa [Polym. J. *4*, 460, (1973)] von 0,08 g mit einer spezifischen Leitfähigkeit von $2{,}7 . 10^{-7}\Omega^{-1}cm^{-1}$ wurde unter Stickstoff 48 Stunden in eine Lösung von 1,0 g $FeCl_3$ in 19 g Acetonitril gelegt. Die Folie wurde mit wenig Acetonitril gewaschen, getrocknet und zeigt ein Gewicht von 0,21 g. Die spezifische Leitfähigkeit einer aus dem Folienmaterial hergestellten Pille beträgt $7{,}6 . 10^{-2}\Omega^{-1}cm^{-1}$ bei einem Druck von 1500 $Kp/cm^2$.

Beispiel 2

Zu 100 ml einer Suspension klettenförmiger Polyacetylenteilchen in Acetonitril, die 150 mg Polyacetylen enthält, fügt man bei Raumtemperatur unter Stickstoff 2,5 g $FeCl_3$ und rührt bis zur vollständigen Lösung des $FeCl_3$. Man überläßt die Suspension 24 Stunden sich selbst und saugt ab. Man erhält eine partiell oxidierte Polyacetylenfolie mit einem Gewicht von 360 mg und einer spezifischen Leitfähigkeit von $6{,}3\times10^2\Omega^{-1}cm^{-1}$ (gemessen nach der 4-Punkt-Methode).

**Patentansprüche**

1. Verfahren zur Erhöhung der elektrischen Leitfähigkeit von Polyacetylen, dadurch gekennzeichnet, daß man Polyacetylen mit einer Verbindung des dreiwertigen Eisens oder dreiwertigen Kobalts teilweise oxidiert (dotiert), ohne dabei schwarzen Phosphor zu verwenden.

2. Verfahren gemäß Anspruch 1, dadurch gekennzeichnet, daß man Polyacetylen in einer Suspension mit einer im Suspendiermittel löslichen Verbindung des dreiwertigen Eisens oder dreiwertigen Kobalts teilweise oxidiert.

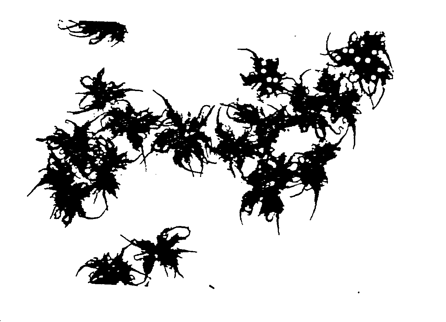

3. Verfahren gemäß Anspruch 1, dadurch gekennzeichnet, daß man klettenförmige Polyacetylenteilchen mit einem Durchmesser von 0,01—1 mm gemäß Abbildung 1 in Suspension mit einer im Suspendiermittel löslichen Verbindung des dreiwertigen Eisens oder dreiwertigen Kobalts teilweise oxidiert.

4. Verwendung des partiell oxidierten Polyacetylens erhalten nach dem Verfahren gemäß Ansprüchen 1—3 als elektrischen Leiter, Halbleiter oder Photoleiter.

**Revendications**

1. Procédé pour élever la conductivité électrique de polyacétylène, caractérisé en ce qu'on oxyde partiellement (dope) un polyacétylène avec un composé du fer trivalent ou du cobalt trivalent, sans utiliser alors de phosphore noir.

2. Procédé suivant la revendication 1, caractérisé en ce qu'on oxyde partiellement un polyacétylène en suspension avec un composé, soluble dans le milieu de mise en suspension, du fer trivalent ou du cobalt trivalent.

3. Procédé suivant la revendication 1, caractérisé en ce qu'on oxyde partiellement des particules de polyacétylène en forme de chardon, ayant un diamètre de 0,01 à 1 mm suivant la figure 1, en suspension avec un composé, soluble dans le milieu de mise en suspension, du fer trivalent ou du cobalt trivalent.

4. Utilisation du polyacétylène partiellement oxydé obtenu par le procédé suivant les revendications 1 à 3 comme conducteur électrique, semi-conducteur ou photoconducteur.

**Claims**

1. Process for increasing the electrical conductivity of polyacetylene, characterised in that polyacetylene is partially oxidised (doped) with a compound of trivalent iron or trivalent cobalt, without using black phosphorus.

2. Process according to Claim 1, characterised in that polyacetylene is partially oxidised in a suspension with a compound of trivalent iron or trivalent cobalt which is soluble in the suspending agent.

3. Process according to Claim 1, characterised in that burr-shaped polyacetylene particles with a diameter of 0.01—1 mm according to Figure 1 are partially oxidised in suspension with a compound of trivalent iron or trivalent cobalt which is soluble in the suspending agent.

4. Use of the partially oxidised polyacetylene obtained by the process according to Claims 1—3 as an electrical conductor, semiconductor or photoconductor.